# EUROPÄISCHE PATENTSCHRIFT

(11) **EP 3 358 674 B1**
(45) Veröffentlichungstag und Bekanntmachung des Hinweises auf die Patenterteilung: **28.10.2020**
(21) Anmeldenummer: 18153562.6
(22) Anmeldetag: 26.01.2018
(51) Int. Cl.: H01Q 1/38, H01Q 1/27, H05K 1/02, B33Y 80/00, H05K 1/03, H05K 1/09, H05K 3/12

(54) **BIEGSAME ANTENNENANORDNUNG**
FLEXIBLE ANTENNA ARRANGEMENT
DISPOSITIF D'ANTENNE SOUPLE

(30) Priorität: 01.02.2017 DE 202017100537 U
(43) Veröffentlichungstag der Anmeldung: 08.08.2018
(73) Patentinhaber: Astra Gesellschaft Für Asset Management MbH&Co. Kg, 30890 Barsinghausen (DE)
(72) Erfinder: Stobbe, Anatoli, 30890 Barsinghausen (DE); Maaß, Norman, 30455 Hannover (DE)
(74) Vertreter: Patentanwälte Thömen & Körner

(56) Entgegenhaltungen:
- EP-A1- 2 200 410
- WO-A1-2016/145309
- US-A1- 2006 289 469
- US-A1- 2008 218 419
- US-B1- 6 412 701

## Beschreibung

Die Erfindung betrifft eine biegsame Antennenanordnung nach dem Oberbegriff des Anspruchs 1.

Aus der DE 102008027246 A1 ist ein waschbares Produkt mit einem berührungslos lesbaren UHF-Detektierplättchen bekannt, das eine Dipolantenne aus einem Multifilamentleiter mit einem Kunststoffmantel umfasst.

Antennenstrukturen in und auf Textilien müssen hinsichtlich Biegsamkeit und Dehnbarkeit mit den Textilien selbst verträglich sein. Sowohl beim bestimmungsgemäßen Benutzen der Textilien als auch beim Waschen entstehen hohe mechanische Beanspruchungen, die die Funktionsfähigkeit der Antennenstrukturen gefährden können. Darüber hinaus gibt es auch thermische und chemische Einwirkungen, denen die Antennenstrukturen zur Bewahrung ihrer Funktionsfähigkeit standhalten müssen.

Aus der US 2006/0289469 A1 ist eine Antennenstruktur aus mehreren parallel verlaufenden leitfähigen Fasern bekannt, die auf einem flexiblen Gewebe aus einem nichtleitenden Material angeordnet sind. In einer Ausführung hat die Antennenstruktur die Form einer Fliege und in einer anderen Ausführung die Form eines Dipols.

Aus der US 2008/0218419 A1 ist ferner eine Antenne aus mehreren parallel angeordneten linearen Leitern bekannt, die zwischen Isolierfilmen angeordnet sind. Alle Leiter sind an einem gemeinsamen Einspeisepunkt miteinander verbunden, aber in unterschiedlichen Abständen vom Einspeisepunkt geschnitten. Auf diese Weise sind mehrere parallel angeordnete gespeiste Elemente unterschiedlicher Länge und parasitäre Elemente gebildet, wodurch die gespeisten Elemente unterschiedliche Resonanzfrequenzen aufweisen. Dadurch erhält die Antenne breitbandige Eigenschaften.

Der Erfindung liegt die Aufgabe zugrunde, eine biegsame Antennenanordnung zu schaffen, deren Antenneneigenschaften, wie hochfrequente elektrische Leitfähigkeit, Eingangsimpedanz und Resonanz während der geplanten Lebensdauer des Textils weitgehend unverändert erhalten bleiben.

Diese Aufgabe wird bei einer biegsamen Antennenanordnung nach dem Oberbegriff des Anspruchs 1 durch die Merkmale dieses Anspruchs gelöst.

Weiterbildungen und vorteilhafte Ausgestaltungen ergeben sich aus den Unteransprüchen.

Die erfindungsgemäße biegsame Antennenanordnung umfasst einen mehradrigen Antennenleiter, der aus mehreren auf einem elektrisch nicht leitfähigen Träger angeordneten, parallel zueinander verlaufenden Leiterbahnen besteht. Die Leiterbahnen sind elektrisch gegenseitig isoliert. Die Maßnahme beruht auf der Überlegung, dass, je dünner der Leiter ist, desto widerstandsfähiger er gegen wiederholte Biegebeanspruchung ist. Der Grund liegt darin, dass der gesamte Leiterquerschnitt praktisch in der neutralen Faser liegt und diese neutrale Faser bei Biegung keiner Stauchung oder Dehnung unterliegt. Der für die Leitfähigkeit ungünstige kleine Leiterquerschnitt einer einzelnen Leiterbahn wird durch die mehrfach vorhandenen Leiterbahnen wieder ausgeglichen, indem diese sich zu einem größeren Gesamtquerschnitt aufsummieren.

Der Antennenleiter weist zusätzliche vorteilhafte Eigenschaften auf. So werden galvanische Unterbrechungen einer oder mehrerer Leiterbahnen durch kapazitive Kopplung der Leiterbahnen mit benachbarten Leiterbahnen überbrückt. Selbst bei Unterbrechungen sämtlicher Leiterbahnen können noch Ströme fließen, wenn die Unterbrechungen an örtlich versetzten Stellen auftreten.

Die Leiterbahnen sind übereinander und nebeneinander angeordnet und zwischen den übereinander und nebeneinander angeordneten Leiterbahnen ist jeweils eine elektrisch nicht leitfähige Isolierschicht angeordnet.

Der elektrisch wirksame Querschnitt des Leiters ist auf mehrere Leiterbahnen aufgeteilt und erstreckt sich in beabstandeten Lagen oberhalb der Oberfläche des Trägers. Zwischen den Lagen der Leiterbahnen befinden sich Schichten aus Isoliermaterial. Die jeweils unter einer Leiterbahn befindliche Isolierschicht bildet gleichzeitig den Träger für die darüber liegende Leiterbahn. Bei Biegungen um einen senkrecht zur Oberfläche des Trägers weisenden Biegeradius liegen Leiterbahnen oder Isolierschichten sowohl in der neutralen Faser als auch mit Abstand zur neutralen Faser und werden dann unterschiedlich auf Stauchung und/oder Dehnung beansprucht. Sind die Leiterbahnen, Isolierschichten und der Träger aber sehr dünn, so ist der Abstand der äußeren Leiterbahnen und Isolierschichten sowie des Trägers von der neutralen Faser so gering, dass auch die Dehnung und Stauchung bei Biegungen um einen senkrecht zur Oberfläche des Trägers weisenden Biegeradius und die mechanische Beanspruche der Leiterbahn und Isolierschichten sehr gering sind. Die oberste Leiterbahn muss keine weitere Isolierschicht tragen. Allerdings kann eine zusätzliche Isolierschicht zum Schutz gegen Umwelteinflüsse auf die Leiterbahnen sinnvoll sein. Da für eine gute Leitfähigkeit des Leiters ein ausreichender Leiterquerschnitt vorhanden sein muss, können die Leiterbahnen breit ausgelegt werden. Auf diese Weise wird eine geringe Höhe der Leiterbahnen ausgeglichen.

Zusätzlich sind Leiterbahnen auf der Ebene des Trägers angeordnet und weisen einen gegenseitigen Abstand zueinander auf.

Der elektrisch wirksame Querschnitt des Leiters erstreckt sich in der Ebene des Trägers auf die Breite. Bei Biegeradien senkrecht zur Ebene des Trägers liegt die neutrale Faser in unmittelbarer Nähe der Leiterbahnen, so dass die Leiterbahnen bei diesem Biegefall nahezu nicht gestaucht oder gedehnt werden. Wenn Belastungen in andere Richtungen ausgeschlossen werden, kann auf eine besondere Materialauswahl der Leiterbahnen zur Berücksichtigung einer elastische Dehn- und Stauchbarkeit verzichtet werden. Ebenso kann auf eine elastische dehn- und stauchbare Isolierschicht verzichtet werden, da der Träger bereits elektrisch nicht leitfähig ist bei einlagigen Leiterbahnen unter elektrischen Gesichtspunkten auf zusätzliches Isoliermaterial verzichtet werden kann. Allerdings kann eine zusätzliche Isolierschicht zum Schutz gegen Umwelteinflüsse auf die Leiterbahnen sinnvoll sein.

Durch Unterbrechungen der Leiterbahnen erscheint der Antennenleiter künstlich gealtert, wodurch sich die Impedanz der Einspeisung im weiteren Betrieb weniger ändert als bei anfangs unterbrechungsfreien Leiterbahnen.

Bei Unterbrechungen von Leiterbahnen an einer Stelle sein, an der eine parallele Leiterbahn durchgängig ist, wird die Unterbrechung kapazitiv überbrückt, so dass die Antenne weiter funktionsfähig bleibt. Außerdem verändern sich die Antenneneigenschaften, wie Strahlungswiderstand und Fußpunktwiederstand bei weiteren Unterbrechungen weniger stark, wenn bereits mehrere Unterbrechungen vorhanden sind.

Im Fall, dass Dehnungen und Stauchungen berücksichtigt werden müssen, bestehen die Leiterbahnen aus einem stauch- und dehnbaren, dauerelastischen Material.

In diesem Fall sind die Leiterbahnen durch geeignete Materialauswahl auf mögliche Dehnung und Stauchung ausgelegt und können derartige Belastungen unbeschädigt aushalten.

Ebenso vorteilhaft besteht die elektrisch nicht leitfähige Isolierschicht aus einem stauch- und dehnbaren, dauerelastischen Material.

Dann ist auch die elektrisch nicht leitfähige Isolierschicht ebenso wie die Leiterbahnen auf mögliche Dehnung und Stauchung ausgelegt und kann derartige Belastungen unbeschädigt aushalten. Darüber hinaus kann die Isolierschicht auch eine bei Biegung mögliche gegenseitige Verlagerung benachbarter Leiterbahnen unbeschadet mitmachen.

Die Leiterbahnen können aus Metall, nämlich Kupfer, Silber, Gold oder Edelstahl oder aus Kohlenstoff oder aus Nanopartikel, die mit Metall-Molekülen oder -Atomen oder ionisierten Salzen versehen und in einem Bindemittel eingebettet sind, oder aus elektrisch leitenden Polymeren bestehen.

Metalle besitzen die geringsten spezifischen Widerstände unter den elektrischen Leitern und eignen sich für Antennen mit niedriger Eingangsimpedanz, wie in der Mitte gespeiste Dipole oder Schleifen. Allerdings führt häufiges Biegen zuerst zu einer Kaltverfestigung und dann zum Bruch der Leiterbahnen.

Die weiter genannten elektrischen Leiter weisen höhere spezifische Widerstände auf und eignen sich als Antennen mit hoher Eingangsimpedanz, wie endgespeiste Dipole. Unterbrechungen einzelner Leiterbahnen werden kapazitiv durch parallele Leiterbahnen überbrückt und so geheilt. Kaltverfestigungen treten nicht auf.

Die Leiterbahnen und/oder die elektrisch nicht leitfähige Isolierschicht können durch Drucktechnik mittels 2-D- oder 3-D-Digitaldruck oder durch Tampondruck oder durch Siebdruck oder durch Kondensation aus einer Dampfphase oder durch Galvanik auf den Träger aufgebracht sein.

Dies ermöglicht es, je nach Anwendungsgebiet, Labormuster, Prototypen oder Serienprodukt elektrischen Leiterbahnen für Antennen zu fertigen.

Nachfolgend wird die Erfindung an Beispielen erläutert, die in der Zeichnung dargestellt und anschließend beschrieben sind.
- Fig. 1: zeigt eine Schnittdarstellung eines als Antennenleiter ausgebildeten elektrischen Leiters, bestehend aus einzelnen Leiterbahnen, die sich ausschließlich senkrecht zur Ebene des Trägers erstrecken
- Fig. 2: zeigt eine perspektivische Darstellung eines als Antennenleiter ausgebildeten elektrischen Leiters, bestehend aus vier parallelen Leiterbahnen auf einem planen Träger,
- Fig. 3: zeigt eine perspektivische Darstellung eines als Antennenleiter ausgebildeten elektrischen Leiters ähnlich Fig. 2 auf einem teilweise gebogenen Träger mit einem Biegeradius senkrecht zur Fläche des Trägers,
- Fig. 4: zeigt eine perspektivische Darstellung eines als Antennenleiter ausgebildeten elektrischen Leiters ähnlich Fig. 2 auf einem teilweise gebogenen Träger mit einem Biegeradius parallel zur Fläche des Trägers,
- Fig. 5: zeigt eine Schnittdarstellung eines als Antennenleiter ausgebildeten elektrischen Leiters, bestehend aus einzelnen Leiterbahnen, die sich sowohl zur Ebene des Trägers als auch senkrecht dazu erstrecken.

Sämtliche in der Zeichnung dargestellten Beispiele zeigen einen als Antennenleiter ausgebildeten elektrischen Leiter 10, der auf einem biegsamen, elastischen, elektrisch nicht leitfähigen Träger 12 angeordnet ist. Der Träger ist hier eine Folie 12 aus einem Kunststoff, der ausschließlich elektrisch nicht leidende Polymere enthält. Zum Drucken auf einen Träger geeignet ist als Träger ein dehnbares Kunststoffsubstrat, zum Beispiel Polyurethan, welches idealerweise als reaktiver oder thermoplastischer Heißkleber ausgelegt ist.

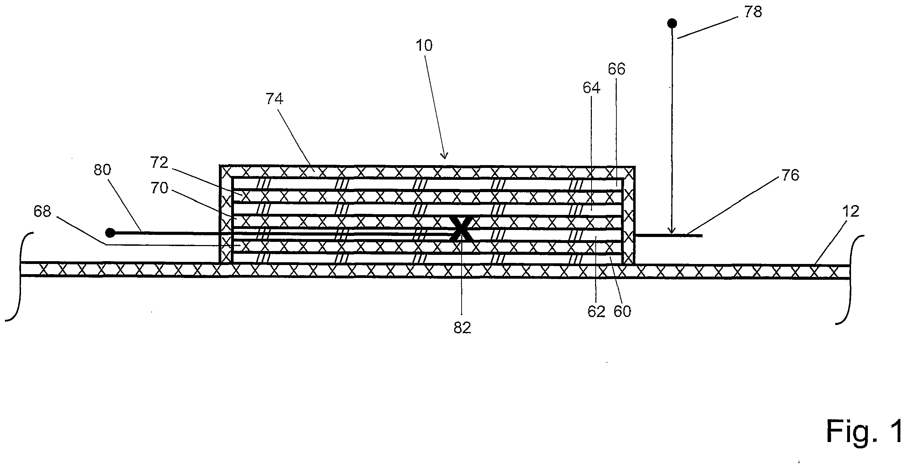

Fig. 1 zeigt eine Schnittdarstellung eines elektrischen Leiters 10, bestehend aus einzelnen Leiterbahnen, die sich senkrecht zur Ebene des Trägers erstrecken. Als Träger dient eine Folie 12. Eine erste Leiterbahn 60 ist unmittelbar auf der Folie 12 angeordnet. Die weiteren Leiterbahnen 62, 64, 66 sind in mehreren Lagen bündig übereinander angeordnet und jeweils durch eine Schicht aus Isoliermaterial 68, 70, 72 voneinander getrennt. Jede Schicht aus Isoliermaterial 68, 70, 72 dient der darüber befindlichen Leiterbahn 62, 64, 66 als Träger. Die oberste Lage Leiterbahn 68 kann ohne Isoliermaterial auf ihrer von der Folie 12 abweisenden Oberfläche auskommen. Allerdings kann eine zusätzliche Isolierschicht 74, wie sie In Fig. 1 vorhanden ist und auch die übrigen Lagen Leiterbahnen 60, 62, 64 seitlich abdeckt, zum Schutz gegen Umwelteinflüsse auf die Leiterbahnen sinnvoll sein.

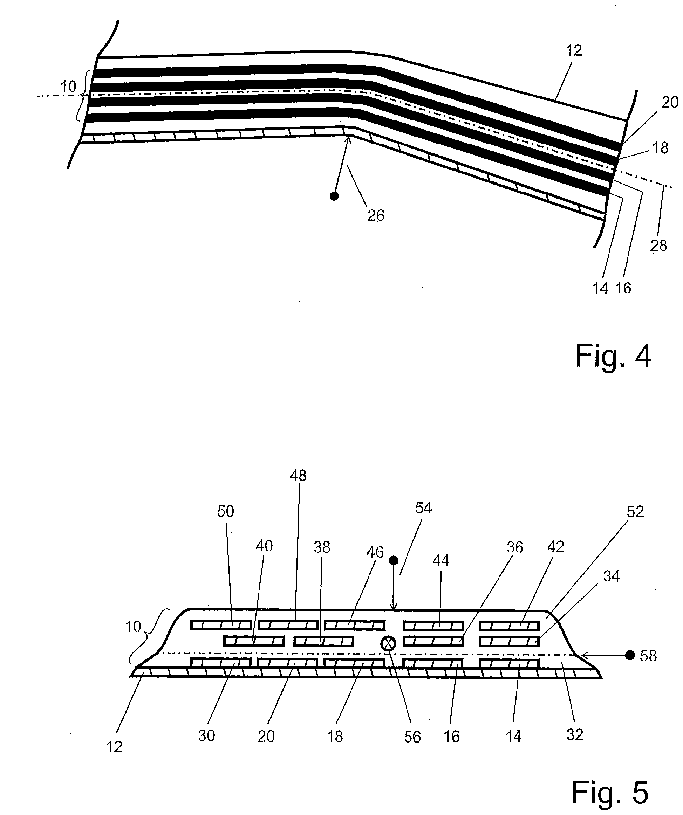

Im Falle einer Biegung um einen Biegeradius 78 senkrecht zur Oberfläche der Folie 12, verläuft eine neutrale Faser 76 oberhalb der Folie 12 und je nach Anzahl der Lagen an Leiterbahnen werden an der Außenseite der Biegung die Leiterbahnen, das Isoliermaterial und die Folie gedehnt und auf der Innenseite der Biegung die Leiterbahnen, das Isoliermaterial und die Folie gestaucht. Im Falle einer Biegung um einen Biegeradius 80 parallel zur Folienfläche werden die Leiterbahnen und das Isoliermaterial ebenfalls gedehnt bzw. gestaucht, wie es im Beispiel nach Fig. 4 der Fall ist. Dabei wirkt sich die Dehnung und Stauchung dann auf alle Lagen der Leiterbahnen und Schichten des Isoliermaterials aus. Am geringsten ist die Beanspruchung, wenn die Biegung so verläuft, dass die neutrale Faser 82 durch die Mitte der Leiterbahnen und Isolierschichten verläuft.

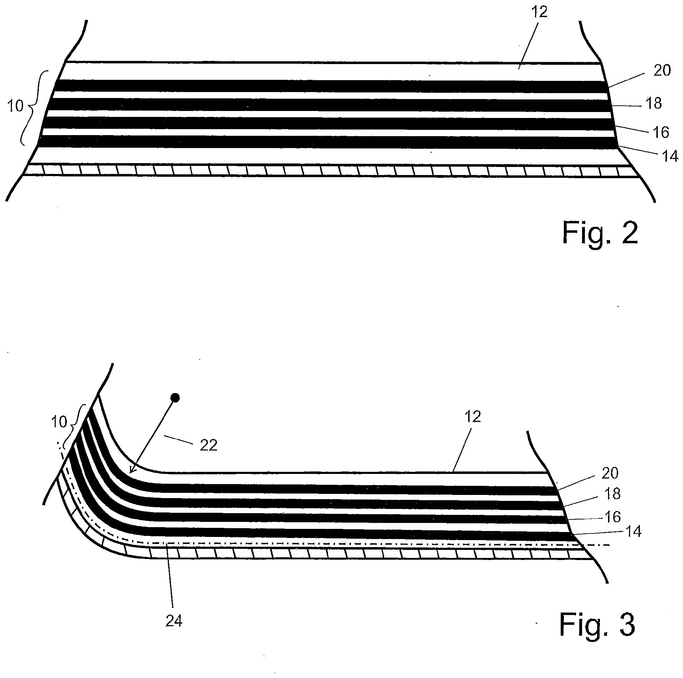

In der perspektivischen Darstellung nach Fig. 2 sind auf der Folie 12 vier parallel zueinander verlaufenden Leiterbahnen 14, 16, 18, 20 angeordnet und sichtbar. Die Leiterbahnen 14,16, 18, 20 liegen unmittelbar auf der Oberfläche der Folie 12 und weisen Querschnitte auf, deren Breitenmaß wenigstens um das Fünffache größer als deren Höhenmaß ist. Der Abstand zwischen den Leiterbahnen 14, 16, 18, 20 ist um wenigstens das Fünffache kleiner als das Breitenmaß der Leiterbahnen. Die Leiterbahnen können aus Metall, vorzugsweise Kupfer, Silber oder Gold, aus Kohlenstoff, aus Nanopartikeln mit metallischen Bestandteilen oder aus elektrisch leitenden Polymeren bestehen.

Fig. 3 zeigt eine perspektivische Darstellung des gleichen Leiters 10 aus Fig. 2, jedoch ist die Folie 12 mit den Leiterbahnen 14, 16, 18, 20 um einen senkrecht zur Folienoberfläche weisenden Biegeradius 22 gebogen. In dieser Darstellung ist auch eine neutrale Faser 24 eingezeichnet, innerhalb der bei Biegung keine Dehnung oder Stauchung auftritt. Diese neutrale Faser 24 liegt etwas oberhalb der Mitte des Querschnitts der die Leiterbahnen 14, 16, 18, 20 tragenden Folie 12. Da die Folie 12 selbst dünn ist und auch die Leiterbahnen 14, 16, 18, 20 nur eine geringe Höhenausdehnung aufweisen, liegen die Leiterbahnen 14, 16, 18, 20 somit sehr dicht an der neutralen Faser 24 und werden bei einer Biegung um den senkrecht zur Folienoberfläche weisenden Biegeradius 22 nur geringfügig belastet. Es ist hier daher möglich, für die Leiterbahnen 14, 16, 18, 20 ein Material einzusetzen, das nur in geringem Maße dehnbar oder stauchbar ist, so dass als Leiterbahnen hier auch Metalle einsetzbar sind. Ein ausreichender Leiterquerschnitt wird dadurch erzielt, dass die Leiterbahnen 14, 16, 18, 20 ein wesentlich größeres Breitenmaß als Höhenmaß aufweisen. Je größer das Verhältnis aus Breitenmaß zu Höhenmaß jeder einzelnen Leiterbahn ist, desto geringer ist die Beanspruchung durch Biegung.

Fig. 4 zeigt eine weitere perspektivische Darstellung des Leiters 10 aus Fig. 2 jedoch ist die Folie 12 mit den Leiterbahnen14, 16, 18, 20 um einen in der Folienebene liegenden Biegeradius 26 gebogen. Auch hier ist wieder die neutrale Faser 28 eingezeichnet, entlang der keine Dehnung oder Stauchung auftritt. Mit zunehmendem Abstand von der neutralen Faser 28 unterliegen die Leiterbahnen 14, 16, 18, 20 einer Dehnung bzw. Stauchung. Die Dehnung tritt auf der Außenseite der Biegung und die Stauchung auf der Innenseite der Biegung auf. Um diesen Biegefall unbeschädigt mitmachen zu können, müssen die Leiterbahnen 14, 16, 18, 20 aus einem dehnbaren und stauchbaren Material bestehen. Geeignet sind hier elektrisch leitfähige Materialien aus Nanopartikel, die mit Metall-Molekülen oder - Atomen oder ionisierten Salzen versehen und in einem Bindemittel eingebettet sind oder elektrisch leitfähige Polymere.

Fig. 5 zeigt eine Schnittdarstellung eines elektrischen Leiters 10 nach einem Ausführungsbeispiel, bestehend aus einzelnen Leiterbahnen 14, 16, 18, 20, die sich sowohl zur Ebene des Trägers als auch senkrecht dazu erstrecken. Als Träger dient wiederum eine Folie 12, auf der 14, 16, 18, 20 perspektivischen Darstellungen von Fig. 1 bis Fig. 4 zu sehen sind. Während die elektrischen Leiter mit einlagigen Leiterbahnen nach den Figuren 1-3 ohne zwischenliegendes Isoliermaterial auskommen, da der Träger selbst elektrisch nichtleitend ist und ansonsten die umgebende Atmosphäre ebenfalls elektrisch nichtleitend ist, ist bei dem Ausführungsbeispiel nach Fig. 5 die unmittelbar auf der Folie 12 angeordnete Lage Leiterbahnen 14, 16, 18, 20, 30 mit Isoliermaterial 32 überzogen. Dieses Isoliermaterial 32 trennt eine zweite Lage Leiterbahnen 34, 36, 38, 40 von der ersten Lage Leiterbahnen 14, 16, 18, 20 und dient gleichzeitig als Träger für die zweiten Lage Leiterbahnen 34, 36, 38, 40. Für den Fall, dass noch weitere Lagen Leiterbahnen 42, 44, 46, 48, 50 angeordnet werden sollen, wie es im Ausführungsbeispiel nach Fig. 5 ebenfalls vorgesehen ist, sind noch weitere Schichten Isoliermaterial 52 anzubringen. Das Isoliermaterial 32, 52 setzt sich dann auch seitlich zwischen die beanstandeten Leiterbahnen 14, 16, 18, 20, 30; 34, 36, 38, 40, 50 und 42, 44, 46, 48.

Die Leiterbahnen 14, 16; 34, 36; 42, 44, 46 können bündig übereinander angeordnet sein, wie es im rechten Teil der Darstellung nach Fig. 5 der Fall ist, oder wechselweise versetzt und somit von Lage zu Lage überlappend, wie es im linken Teil mit den Leiterbahnen 18, 20; 38, 40, 50; 46, 48 nach Fig. 5 gezeichnet ist.

Im Falle einer Biegung analog zu Fig. 3 also um einen Biegeradius 54 senkrecht zur Folie 12, verläuft die neutrale Faser 56 oberhalb der Folie 12 und je nach Anzahl der Lagen an Leiterbahnen werden an der Außenseite der Biegung die Leiterbahnen und auch das Isoliermaterial gedehnt und auf der Innenseite der Biegung die Leiterbahnen, das Isoliermaterial und die Folie gestaucht. Im Falle einer Biegung analog zu Fig. 4, also um einen Biegeradius 58 parallel zur Folienfläche werden die Leiterbahnen und das Isoliermaterial ebenfalls gedehnt bzw. gestaucht, wie es im Beispiel nach Fig. 4 der Fall ist, wobei sich die Dehnung und Stauchung dann auf alle Lagen der Leiterbahnen und Schichten des Isoliermaterials auswirkt.

Für die Leiterbahnen kommen die gleichen Materialien in Betracht, wie sie im Zusammenhang mit dem Beispiel nach Fig. 4 genannten wurden. Auch das Isoliermaterial muss dehnbar sein, wobei hier jedoch eine größere Materialauswahl aus elastischen oder gummielastischen Kunststoffen zur Verfügung steht. Da sich im Falle einer Biegung auch benachbarte Leiterbahnen gegeneinander verschieben, muss das Isoliermaterial zusätzlich auch diese Relativverlagerung mitmachen.

Die Unterteilung des Leiters in eine Mehrzahl oder Vielzahl von Leiterbahnen hat den Vorteil, dass sich eventuelle Beschädigungen einzelner Leiterbahnen nur auf die jeweilige davon betroffene Leiterbahn selbst beschränken und sich nicht weiter fortpflanzen und auf benachbarte Leiterbahnen übertreten. Bei einem durchgehenden Leiter wäre das wegen der Kernwirkung möglich.

Die Beschädigung einzelner Leiterbahnen, die zu einer galvanischen Unterbrechung der betroffenen Leiterbahn führt, wird durch weiterhin intakte Leiterbahnen überbrückt. Bei Wechselstrom sind nämlich benachbarte Leiterbahnen kapazitiv gekoppelt und sofern mehrere Leiterbahnen nicht an derselben örtlichen Stelle unterbrochen sind, überbrückt diese kapazitive Kopplung zwischen den intakten Leiterbahnen die galvanisch unterbrochenen Leiterbahnen. Selbst wenn sämtliche Leiterbahnen unterbrochen sind, allerdings jeweils an unterschiedlichen örtlichen Stellen, bleibt die Leitfähigkeit für Wechselströme hoher Frequenz erhalten.

Die kapazitive Kopplung benachbarter Leiterbahnen ist beim Ausführungsbeispiel nach Fig. 5 besonders eng, insbesondere bei der Ausführung im linken Teil der Fig. 5 mit den sich überlappenden Leiterbahnen. Auch das Isoliermaterial, das ohnehin eine höhere Dielektrizitätskonstante als Luft aufweist, führt zu einer weiteren Steigerung der kapazitiven Kopplung benachbarter Leiterbahnen und kann durch geeignete Auswahl von Materialien mit besonders hoher Dielektrizitätskonstante nochmals verbessert werden.

Die Leiterbahnen und/oder die elektrisch nicht leitfähige Isolierschicht werden durch Drucktechnik mittels 2-D-Digitaldruck, 3-D-Druck oder durch Tampondruck oder durch Siebdruck oder durch Kondensation aus einer Dampfphase oder durch Galvanik auf den Träger aufgebracht ist. Bei Labormustern und Prototypen kommt 2-D- und 3-D-Digitaldruck zur Anwendung, während bei Serienprodukten Tampondruck oder Siebdruck oder Kondensation oder Galvanik angewandt werden. Mittels 3-D-Druck lassen sich nicht nur die Leiterbahnen und das Isoliermaterial aufbringen, sondern auch der Träger selbst herstellen und somit der gesamte Leiter mit seinem Träger in einem Arbeitsgang fertigen.

**Bezugszeichenliste**

| | | | |
|---|---|---|---|
| 10 | Antennenleiter | 50 | Leiterbahn |
| 12 | Träger, Folie | 52 | Isoliermaterial |
| 14 | Leiterbahn | 54 | Biegeradius |
| 16 | Leiterbahn | 56 | neutrale Faser |
| 18 | Leiterbahn | 58 | Biegeradius |
| 20 | Leiterbahn | 60 | Leiterbahn |
| 22 | Biegeradius | 62 | Leiterbahn |
| 24 | neutrale Faser | 64 | Leiterbahn |
| 26 | Biegeradius | 66 | Leiterbahn |
| 28 | neutrale Faser | 68 | Isoliermaterial |
| 30 | Leiterbahn | 70 | Isoliermaterial |
| 32 | Isoliermaterial | 72 | Isoliermaterial |
| 34 | Leiterbahn | 74 | Isoliermaterial |
| 36 | Leiterbahn | 76 | neutrale Faser |
| 38 | Leiterbahn | 78 | Biegeradius |
| 40 | Leiterbahn | 80 | Biegeradius |
| 42 | Leiterbahn | 82 | neutrale Faser |
| 44 | Leiterbahn | | |
| 46 | Leiterbahn | | |
| 48 | Leiterbahn | | |

## Patentansprüche

1. Biegsame Antennenanordnung, bestehend aus einem mehradrigen Antennenleiter (10) auf einem biegsamen, elektrisch nicht leitfähigen Träger (12), wobei der Träger aus einem Film, einer Folie oder einem textilen Flächengebilde besteht, und der Antennenleiter (10) aus mehreren parallel zueinander verlaufenden Leiterbahnen (14, 16, 18, 20, 30, 34, 36, 38, 40, 42, 44, 46, 48, 50) besteht, die elektrisch gegenseitig isoliert sind, wobei die parallel zueinander verlaufenden Leiterbahnen (14, 16, 18, 20, 30, 34, 36, 38, 40, 42, 44, 46, 48, 50) nebeneinander und übereinander angeordnet sind und zwischen den nebeneinander und übereinander angeordneten Leiterbahnen jeweils eine elektrisch nicht leitfähige Isolierschicht (52) angeordnet ist, wobei die Leiterbahnen (14, 16, 18, 20, 30, 34, 36, 38, 40, 42, 44, 46, 48, 50) wenigstens eine Unterbrechung aufweisen und bei mehreren Unterbrechungen mehrerer Leiterbahnen wenigstens eine Unterbrechung an einer Stelle ist, an der eine parallele Leiterbahn durchgängig ist, und die biegsame Antennenanordnung eine neutrale Faser (56) aufweist, die bei Biegung des Trägers (12) mit dem Antennenleiter (10) keiner Stauchung oder Dehnung unterliegt, **dadurch gekennzeichnet, dass** die neutrale Faser (56) durch die Mitte der Leiterbahnen und Isolierschichten verläuft.

2. Biegsame Antennenanordnung nach Anspruch 1, **dadurch gekennzeichnet, dass** die Leiterbahnen (14, 16, 18, 20, 30, 34, 36, 38, 40, 42, 44, 46, 48, 50) aus einem stauch- und dehnbaren, dauerelastischen Material bestehen.

3. Biegsame Antennenanordnung nach Anspruch 1 oder 2, **dadurch gekennzeichnet, dass** die elektrisch nicht leitfähige Isolierschicht (52) aus einem stauch- und dehnbaren, dauerelastischen Material besteht.

4. Biegsame Antennenanordnung nach einem der Ansprüche 1 bis 3, **dadurch gekennzeichnet, dass** die Leiterbahnen (14, 16, 18, 20, 30, 34, 36, 38, 40, 42, 44, 46, 48, 50) aus Metall, nämlich Kupfer, Silber, Gold oder Edelstahl oder aus Kohlenstoff oder aus Nanopartikel, die mit Metall-Molekülen oder -Atomen oder ionisierten Salzen versehen und in einem Bindemittel eingebettet sind, oder aus elektrisch leitenden Polymeren bestehen.

5. Biegsame Antennenanordnung nach einem der Ansprüche 1 bis 4, **dadurch gekennzeichnet, dass** die Leiterbahnen (14, 16, 18, 20, 30, 34, 36, 38, 40, 42, 44, 46, 48, 50) und/oder die elektrisch nicht leitfähige Isolierschicht (52) durch Drucktechnik mittels 2-D- oder 3-D-Digitaldruck oder durch Tampondruck oder durch Siebdruck oder durch Kondensation aus einer Dampfphase oder durch Galvanik auf den Träger aufgebracht ist.

## Claims

1. Flexible antenna arrangement, consisting of a multicore antenna conductor (10) on a flexible, electrically non-conductive carrier (12), wherein the carrier consists of a film, a foil or a sheet-like textile structure, and the antenna conductor (10) consists of a plurality of conductor tracks (14, 16, 18, 20, 30, 34, 36, 38, 40, 42, 44, 46, 48, 50) which run parallel to one another and are electrically insulated from one another, wherein the conductor tracks (14, 16, 18, 20, 30, 34, 36, 38, 40, 42, 44, 46, 48, 50) which run parallel to one another are arranged next to one another and one above the other and an electrically non-conductive insulating layer (52) is respectively arranged between the conductor tracks which are arranged next to one another and one above the other, wherein the conductor tracks (14, 16, 18, 20, 30, 34, 36, 38, 40, 42, 44, 46, 48, 50) have at least one interruption and, when there are a plurality of interruptions in a plurality of conductor tracks, at least one interruption is at a point at which a parallel conductor track is continuous, and the flexible antenna arrangement has a neutral fibre (56) which is not subject to compression or expansion when the carrier (12) is bent with the antenna conductor (10), **characterized in that** the neutral fibre (56) runs through the centre of the conductor tracks and insulating layers.

2. Flexible antenna arrangement according to Claim 1, **characterized in that** the conductor tracks (14, 16, 18, 20, 30, 34, 36, 38, 40, 42, 44, 46, 48, 50) consist of a compressible and expandable, permanently elastic material.

3. Flexible antenna arrangement according to Claim 1 or 2, **characterized in that** the electrically non-conductive insulating layer (52) consists of a compressible and expandable, permanently elastic material.

4. Flexible antenna arrangement according to one of Claims 1 to 3, **characterized in that** the conductor tracks (14, 16, 18, 20, 30, 34, 36, 38, 40, 42, 44, 46, 48, 50) consist of metal, specifically copper, silver, gold or stainless steel, or of carbon or of nanoparticles, which are provided with metal molecules or atoms or ionized salts and are embedded in a binder, or of electrically conductive polymers.

5. Flexible antenna arrangement according to one of Claims 1 to 4, **characterized in that** the conductor tracks (14, 16, 18, 20, 30, 34, 36, 38, 40, 42, 44, 46, 48, 50) and/or the electrically non-conductive insulating layer (52) are/is applied to the carrier by printing technology using 2D or 3D digital printing or by pad printing or by screen printing or by condensation from a vapour phase or by electroplating.

## Revendications

1. Arrangement d'antenne flexible, composé d'un conducteur d'antenne (10) multibrin sur un élément porteur (12) flexible non conducteur d'électricité, l'élément porteur se composant d'un film, d'une feuille ou d'une structure textile plane, et le conducteur d'antenne (10) se composant de plusieurs pistes conductrices (14, 16, 18, 20, 30, 34, 36, 38, 40, 42, 44, 46, 48, 50) qui s'étendent parallèlement les unes aux autres, lesquelles sont isolées électriquement mutuellement, les pistes conductrices (14, 16, 18, 20, 30, 34, 36, 38, 40, 42, 44, 46, 48, 50) qui s'étendent parallèlement les unes aux autres étant disposées les unes à côté des autres et les unes au-dessus des autres et une couche isolante (52) non conductrice d'électricité étant respectivement disposée entre les pistes conductrices qui s'étendent parallèlement les unes aux autres, les pistes conductrices (14, 16, 18, 20, 30, 34, 36, 38, 40, 42, 44, 46, 48, 50) possédant au moins une interruption et, en cas de plusieurs interruptions de plusieurs pistes conductrices, au moins une interruption se trouvant à un endroit auquel ladite piste conductrice parallèle est continue, et l'arrangement d'antenne flexible possédant une fibre neutre (56) qui, lors de la flexion de l'élément porteur (12) avec le conducteur d'antenne (10), ne subit aucun écrasement ni allongement, **caractérisé en ce que** la fibre neutre (56) s'étend à travers le centre des pistes conductrices et des couches isolantes.

2. Arrangement d'antenne flexible selon la revendication 1, **caractérisé en ce que** les pistes conductrices (14, 16, 18, 20, 30, 34, 36, 38, 40, 42, 44, 46, 48, 50) se composent d'un matériau compressible et extensible à élasticité permanente.

3. Arrangement d'antenne flexible selon la revendication 1 ou 2, **caractérisé en ce que** la couche isolante (52) non conductrice d'électricité se compose d'un matériau compressible et extensible à élasticité permanente.

4. Arrangement d'antenne flexible selon l'une des revendications 1 à 3, **caractérisé en ce que** les pistes conductrices (14, 16, 18, 20, 30, 34, 36, 38, 40, 42, 44, 46, 48, 50) sont constituées de métal, à savoir de cuivre, d'argent, d'or ou d'acier inoxydable ou de carbone, ou de nanoparticules qui sont pourvues de molécules ou d'atomes de métal ou de sels ionisés et sont enrobées dans un liant, ou de polymères électriquement conducteurs.

5. Arrangement d'antenne flexible selon l'une des revendications 1 à 4, **caractérisé en ce que** les pistes conductrices (14, 16, 18, 20, 30, 34, 36, 38, 40, 42, 44, 46, 48, 50) et/ou la couche isolante (52) non conductrice d'électricité sont appliquées sur l'élément porteur par technique d'impression au moyen d'une impression numérique 2D ou 3D ou par impression au tampon ou par sérigraphie ou par condensation à partir d'une phase vapeur ou par un procédé galvanique.
